# EUROPÄISCHE PATENTSCHRIFT

(11) **EP 1 507 884 B1**
(45) Veröffentlichungstag und Bekanntmachung des Hinweises auf die Patenterteilung: **23.09.2015**
(21) Anmeldenummer: 03724884.6
(22) Anmeldetag: 09.05.2003
(51) Int. Cl.: C23C 16/04, B08B 9/42, B65G 47/84

(54) **VERFAHREN UND VORRICHTUNG ZUR PLASMABEHANDLUNG VON WERKSTÜCKEN**
METHOD AND DEVICE FOR PLASMA TREATING WORKPIECES
PROCEDE ET DISPOSITIF POUR LE TRAITEMENT AU PLASMA DE PIECES

(30) Priorität: 24.05.2002 DE 10223288; 31.05.2002 DE 10224546
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); LEWIN, Frank, 22889 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55239 Gau-Odernheim (DE); LÜTTRINGHAUS-HENKEL, Andreas, 64289 Darmstadt (DE); BICKER, Matthias, 55126 Mainz (DE); KLEIN, Jürgen, 55127 Mainz (DE)
(74) Vertreter: Hausfeld, Norbert
(86) Internationale Anmeldenummer: PCT/DE2003/001502
(87) Internationale Veröffentlichungsnummer: WO 2003/100116

(56) Entgegenhaltungen:
- WO-A-99/17334
- WO-A1-95/22413
- DE-A- 19 957 744
- US-A- 5 232 717

## Beschreibung

Die Erfindung betrifft ein Verfahren zur Plasmabehandlung von Werkstücken, bei dem das Werkstück in eine zumindest teilweise evakuierbare Plasmakammer einer Behandlungsstation eingesetzt wird und bei dem das Werkstück innerhalb der Behandlungsstation von einem Halteelement positioniert wird.

Die Erfindung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und mindestens ein Halteelement zur Positionierung des Werkstückes aufweist.

Derartige Verfahren und Vorrichtungen werden beispielsweise eingesetzt, um Kunststoffe mit Oberflächenbeschichtungen zu versehen. Insbesondere sind auch bereits derartige Verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

Aus der U.S. 5,232,717 A ist es bekannt, einen Vorformling unter Verwendung eines Transportelementes im Bereich einer Blasmaschine zu transportieren. Ein Mündungsabschnitt des Vorformlings wird hierbei abschnittsweise von einem hülsenförmigen Element umschlossen.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

Die bislang bekannten Verfahren und Vorrichtungen sind noch nicht in ausreichender Weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, dass eine Handhabung der zu behandelnden Werkstücke mit hoher Geschwindigkeit und großer Zuverlässigkeit unterstützt wird.

Diese Aufgabe wird erfindungsgemäß dadurch gelöst, dass zur Abdichtung eines Innenraumes des Werkstückes ein hülsenartiges Dichtelement derart relativ zu einem Kammerboden positioniert wird, dass die Positionierung in einer vertikalen Richtung durchgeführt wird und dass das Dichtelement eine Ringdichtung aufweist, die im abgedichteten Zustand gegen eine Mündungsfläche eines Gewindebereiches des flaschenartig ausgebildeten Werkstückes geführt wird und dass vor einem Einsetzen des Werkstückes in die Kammer das Dichtungselement abgesenkt, dann das Werkstück an das Halteelement übergeben und anschließend das Dichtelement wieder angehoben wird.

Weitere Aufgabe der vorliegenden Erfindung ist es, eine Vorrichtung der einleitend genannten Art derart zu konstruieren, dass eine einfache Bewegungskinematik der zu behandelnden Werkstücke unterstützt wird.

Diese Aufgabe wird erfindungsgemäß dadurch gelöst, dass im Bereich des Kammerbodens ein hülsenartiges Dichtelement angeordnet ist, das relativ zum Kammerboden derart beweglich angeordnet ist, dass das Dichtelement in einer vertikalen Richtung positionierbar ist und dass das Dichtelement eine Ringdichtung aufweist, die im abgedichteten Zustand gegen eine Mündungsfläche eines Gewindebereiches des flaschenartig ausgebildeten Werkstückes geführt wird, sowie dass das Dichtelement relativ zum Kammerboden sowohl absenkbar als auch anhebbar angeordnet ist.

Durch die relativ zum Kammerboden und zum Halteelement positionierbare Anordnung des hülsenförmigen Dichtelements ist es möglich, die zu behandelnden Werkstücke auf einem im wesentlichen gleichbleibenden Höhenniveau zu transportieren. Es wird hierdurch die Zeit für eine gemäß dem Stand der Technik durchzuführende Höhenpositionierung der Werkstücke sowie der hierfür erforderliche konstruktive Aufwand eingespart.

Der verfahrenstechnische Ablauf bei der Handhabung der Werkstücke erfolgt derart, daß zunächst für ein Einsetzen der Werkstücke in die Plasmakammer das Dichtelement zumindest soweit in den Kammerboden hinein versenkt wurde, daß die Werkstücke an das Halteelement übergeben werden können. Nach einer Positionierung der Werkstücke durch das Halteelement innerhalb der Plasmakammer erfolgt zu einem vorgebbaren Zeitpunkt ein Hochfahren des Dichtelementes und hierdurch eine Abdichtung des Innenraumes des Werkstückes relativ zum Innenraum der Plasmakammer.

Eine derartige Abdichtung kann sowohl bereits zu einem Beginn des Evakuierungsvorganges als auch nach einer bereits durchgeführten Teilevakuierung erfolgen. Eine Abdichtung erst nach einer Teilevakuierung weist den Vorteil auf, daß ein Innenraum des Werkstückes und der weitere Innenraum der Plasmakammer zunächst gemeinsam evakuiert werden können und daß in einem zweiten Evakuierungsschritt nach einer Abdichtung des Innenraumes des Werkstückes der Unterdruck im Bereich des Innenraumes des Werkstückes unterschiedlich zum Unterdruck im weiteren Innenraum der Plasmakammer vorgegeben werden kann. Insbesondere ist hierbei daran gedacht, den Unterdruck im Innenraum des Werkstückes tiefer als im weiteren Innenraum der Plasmakammer vorzugeben.

Eine günstige Schwerkrafteinleitung wird dadurch unterstützt, daß die Positionierung in einer vertikalen Richtung durchgeführt wird.

Eine Plasmabehandlung von Werkstücken mit kreisartigem Mündungsabschnitt wird dadurch unterstützt, daß ein Dichtelement mit einer kreisringartigen Querschnittfläche positioniert wird.

Bei einer Beschichtung von hohlen Werkstücken, die mit ihrer Mündung nach unten angeordnet sind, erweist es sich als vorteilhaft, daß eine Evakuierung einer Kavität der Plasmastation durch den Kammerboden hindurch erfolgt.

Eine gerätetechnisch einfache Realisierung wird ebenfalls dadurch unterstützt, daß durch den Kammerboden hindurch Prozeßgas zugeführt wird.

Eine schnelle und gleichmäßige Verteilung des Prozeßgases in einem Innenraum des Werkstückes kann dadurch erreicht werden, daß das Prozeßgas durch eine Lanze hindurch in einen Innenraum des Werkstückes zugeführt wird.

Eine hohe Positioniergenauigkeit wird dadurch unterstützt, daß das Werkstück seitlich von einem Einfassungsflansch des Dichtelementes abgestützt wird.

Insbesondere kann eine Selbstzentrierung beim Zusammenführen des Dichtelementes und des Werkstückes dadurch erreicht werden, daß ein Mündungsbereich des Werkstückes vom Einfassungsflansch abgestützt wird.

Eine aktive Positionierung des Dichtelementes in lediglich eine Richtung kann dadurch erreicht werden, daß das Dichtelement von einer Druckfeder in eine der Plasmakammer abgewandte Richtung gedrückt wird.

Zur Unterstützung einer auch bei einer Einwirkung von äußeren Kräften sicheren Betriebsweise wird vorgeschlagen, daß ein Hubbereich des Dichtelementes von mindestens zwei Anschlägen begrenzt wird.

Eine besonders einfache Positionierung des Dichtelementes kann dadurch durchgeführt werden, daß das Dichtelement mechanisch positioniert wird.

Darüber hinaus ist daran gedacht, daß das Dichtelement pneumatisch positioniert wird.

Zur Unterstützung einer steuerbaren Zündung des Plasmas wird vorgeschlagen, daß im Bereich des Kammerdeckels von einem Mikrowellengenerator erzeugte Mikrowellen in die Kavität eingeleitet werden.

Eine typische Anwendung besteht darin, daß ein Werkstück aus einem thermoplastischen Kunststoff behandelt wird.

Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die mindestens eine Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Eine konstruktive Vereinfachung der Plasmastation kann dadurch erreicht werden, daß das Dichtelement eine Ventilfunktion zur steuerbaren Verbindung und Abtrennung des Innenraumes des Werkstückes und des weiteren Innenraumes der Plasmakammer ausübt.

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird.

Zur Unterstützung eines Ausgleiches von Positionierungstoleranzen wird vorgeschlagen, daß der Einfassungsflansch mit einer innenseitigen Einführanschrägung versehen ist.

Eine wirkungsvolle Abdichtung wird dadurch unterstützt, daß das Dichtelement eine der Plasmakammer zugewandt angeordnete Ringdichtung aufweist.

Zur Vermeidung separater mechanischer Antriebseinrichtungen wird vorgeschlagen, daß das Dichtelement mit einem Lanzenschlitten gekoppelt ist.

Eine sehr kompakte Ausführungsform kann dadurch erreicht werden, daß das Dichtelement mit einer Lanze zur Prozeßgaszuführung gekoppelt ist.

Insbesondere ist daran gedacht, daß die Lanze zur Positionierung des Dichtelementes mit einem Schubteller versehen ist.

Eine von einer Positionierung der Lanze unabhängige Positionierung des Dichtelementes kann dadurch erreicht werden, die pneumatische Positioniereinrichtung eine Überdrucksteuerung aufweist.

Ebenfalls ist es zur Vermeidung einer separaten Überdruckzuführung auch möglich, daß die pneumatische Positioniereinrichtung eine Unterdrucksteuerung aufweist.

Eine einfache Ansteuerung der Plasmakammer zur Vorgabe unterschiedlicher Unterdrücke innerhalb des Werkstückes und innerhalb der Plasmakammer außerhalb des Werkstückes wird vorgeschlagen, daß das Dichtelement zur steuerbaren Verbindung und Abtrennung eines Innenraumes der Plasmakammer mit einer Unterdruckquelle ausgebildet ist.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe- und Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6,
- Fig. 10: eine nochmals vergrößerte Darstellung eines Anschlußelementes zur Halterung des Werkstückes in der Plasmakammer,
- Fig. 11: eine schematische Darstellung einer Positionierung eines flaschenförmigen Werkstückes innerhalb der Plasmakammer unter Verwendung eines zangenartigen Halteelementes und
- Fig. 12: eine Darstellung ähnlich zu Fig. 10 bei einer gegenüber Fig. 10 abgesenkten Positionierung des hülsenartigen Dichtelementes.

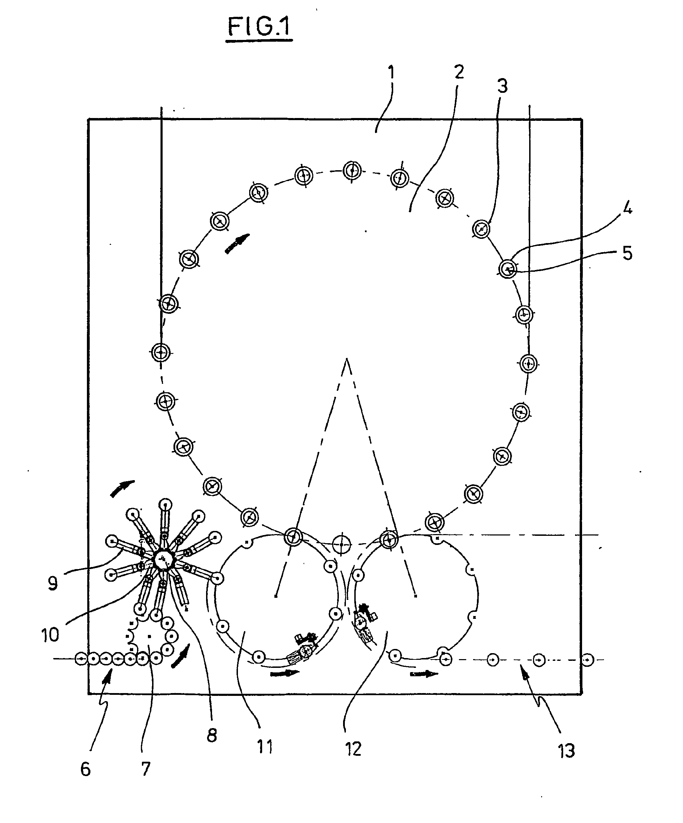

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

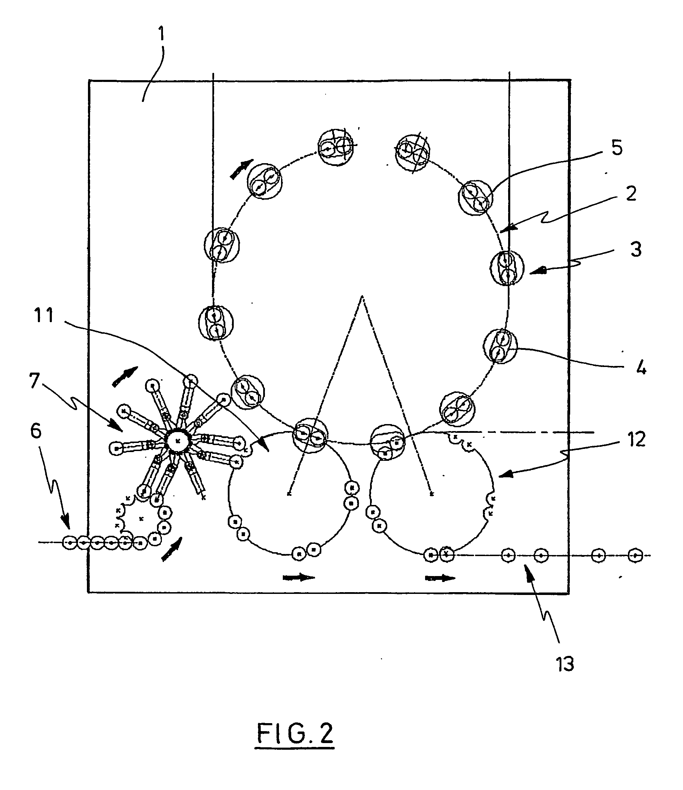

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

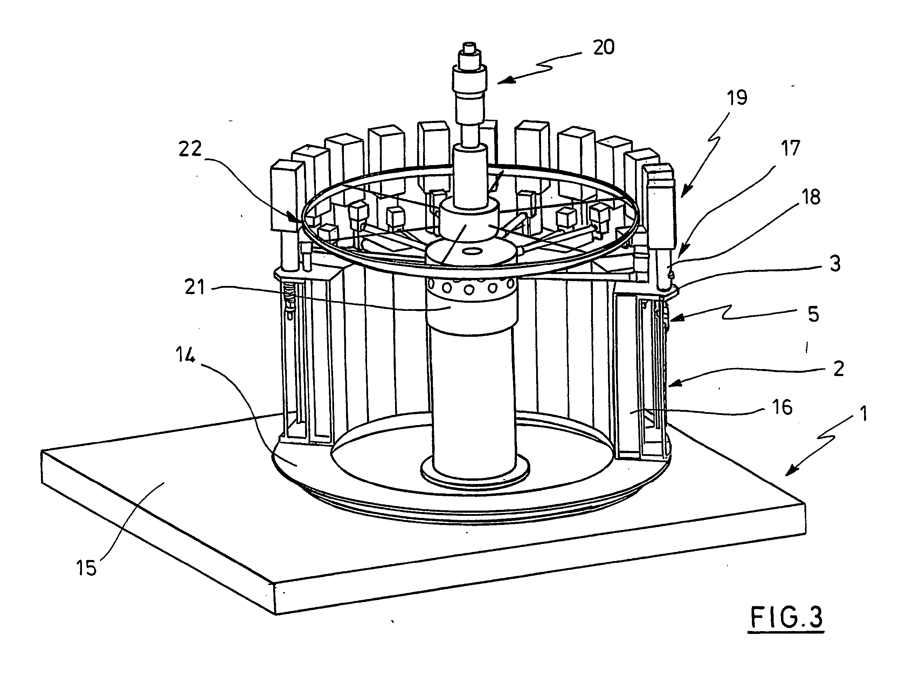

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

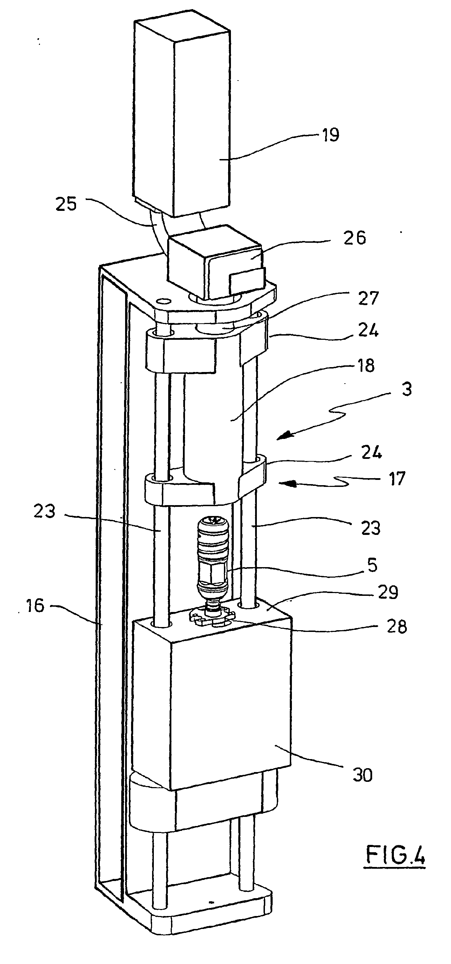

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird im Bereich eines Dichtelementes (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

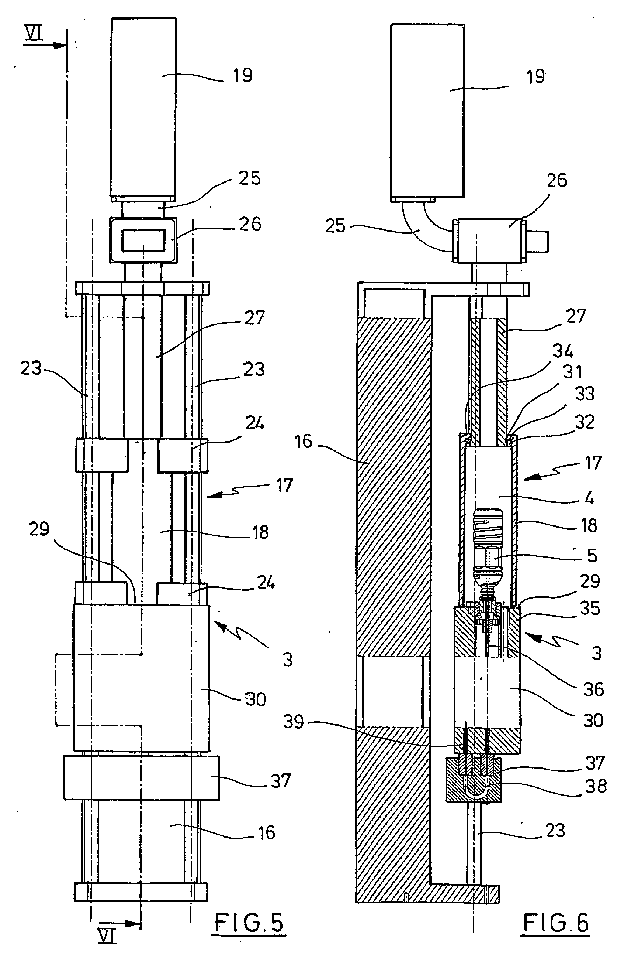

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

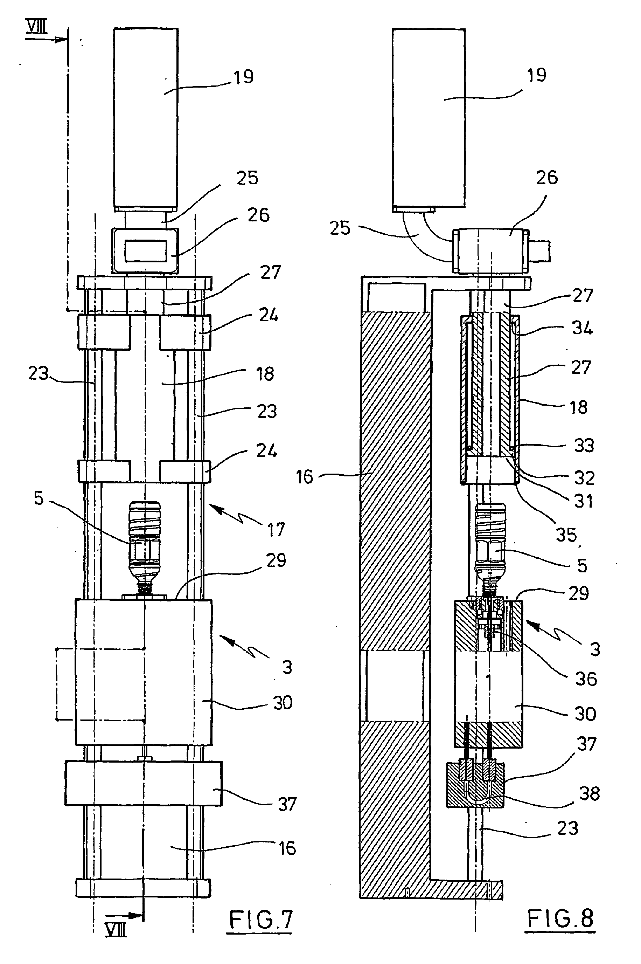

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

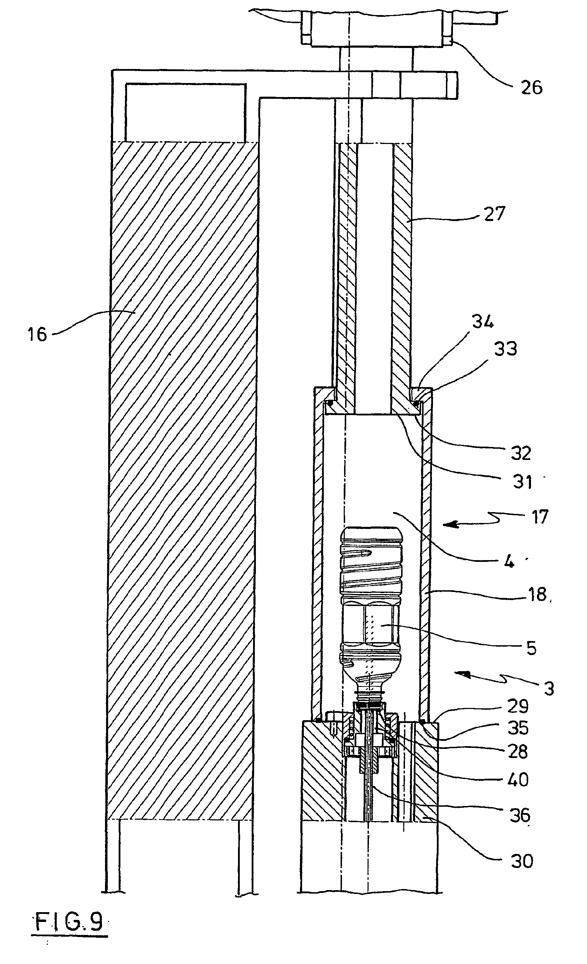

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Halteelement (28). Darüber hinaus ist zu erkennen, daß die Lanze (36) durch eine Ausnehmung (40) des Halteelementes (28) hindurchgeführt ist.

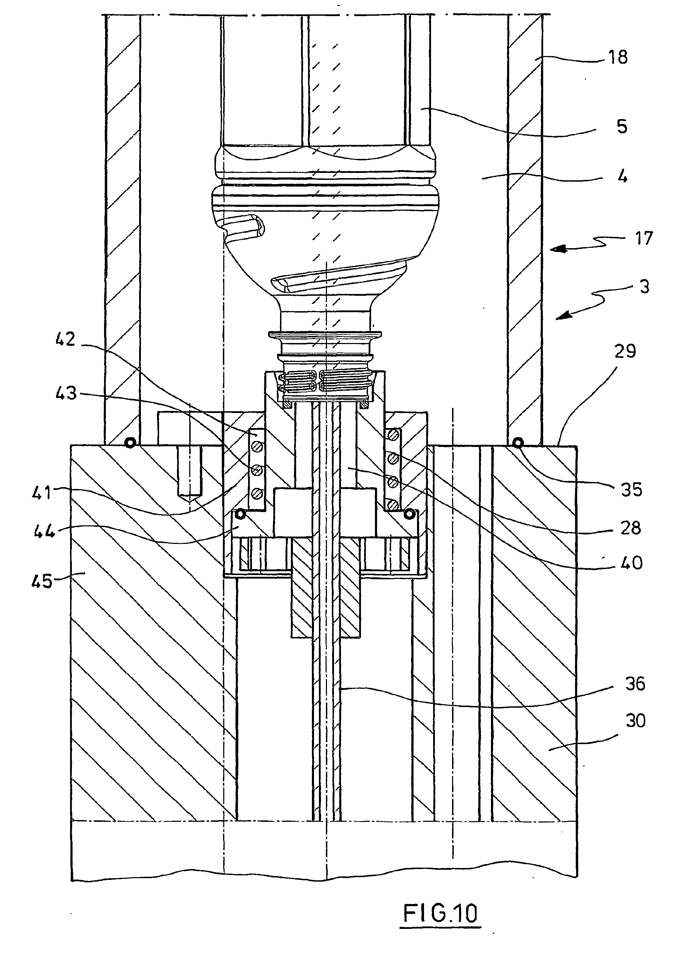

Die Positionierung des Werkstückes (5) im Bereich des Dichtelementes (28) ist in der nochmals vergrößerten Darstellung in Fig. 10 zu erkennen. Das Dichtelement (28) ist in eine Führungshülse (41) eingesetzt, die mit einer Federkammer (42) versehen ist. In die Federkammer (42) ist eine Druckfeder (43) eingesetzt, die einen Außenflansch (44) des Dichtelementes (28) relativ zur Führungshülse (41) verspannt.

In der in Fig. 10 dargestellten Positionierung ist ein an der Lanze (36) montierter Schubteller (45) gegen den Außenflansch (44) geführt und drückt das Dichtelement (28) in seine obere Endpositionierung. In dieser Positionierung ist ein Innenraum des Werkstückes (5) gegenüber dem Innenraum der Kavität (4) isoliert. In einem abgesenkten Zustand der Lanze (36) verschiebt die Druckfeder (43) das Dichtelement (28) relativ zur Führungshülse (41) derart, daß eine Verbindung zwischen dem Innenraum des Werkstückes (5) und dem Innenraum der Kavität (4) geschaffen ist.

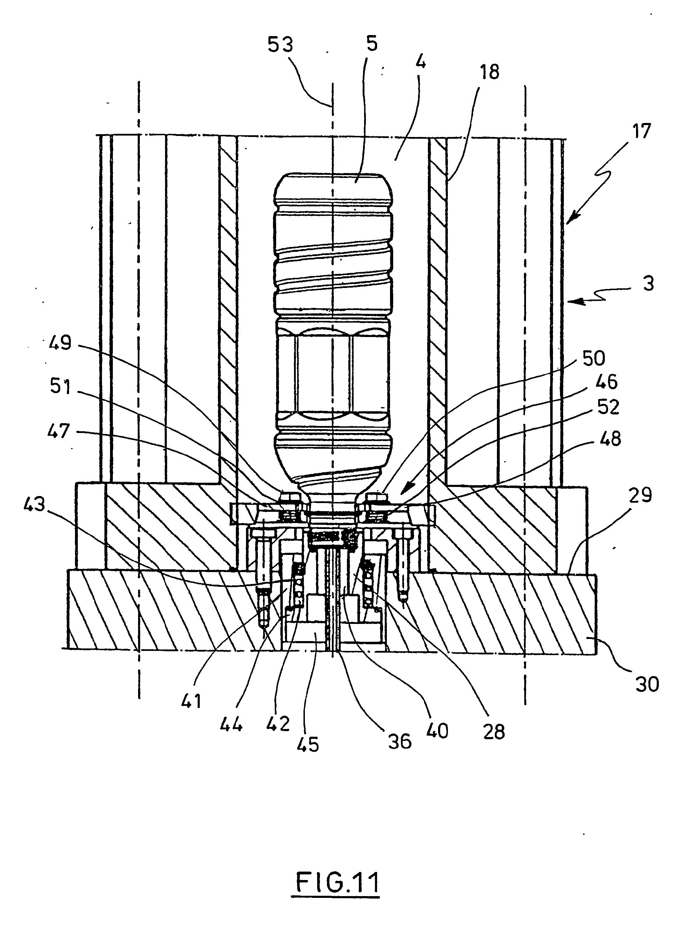

Fig. 11 zeigt die Positionierung des Werkstückes (5) innerhalb der Plasmakammer (17) mit Hilfe eines Halteelementes (46). Das Halteelement (46) ist zangenartig ausgebildet und besitzt zwei verschwenkbar gelagerte Haltearme (47, 48). Die Haltearme (47, 48) sind relativ zu Drehachsen (49, 50) verschwenkbar. Zur Gewährleistung einer automatischen Fixierung des Werkstückes (5) durch das Halteelement (46) werden die Haltearme (47, 48) von Federn (51, 52) in eine jeweilige Haltepositionierung gedrückt.

Das Halteelement (46) ist oberhalb des Kammersockels (30) angeordnet, so daß nach einem Anheben der Kammerwandung (18) eine seitliche Zugänglichkeit des Halteelements (46) gegeben ist. Das Werkstück (5) kann hierdurch von einem Positionierelement an das Halteelement (46) übergeben werden, ohne daß eine Hubbewegung des Werkstückes (5) in Richtung einer Kavitätenlängsachse (53) erfolgen muß.

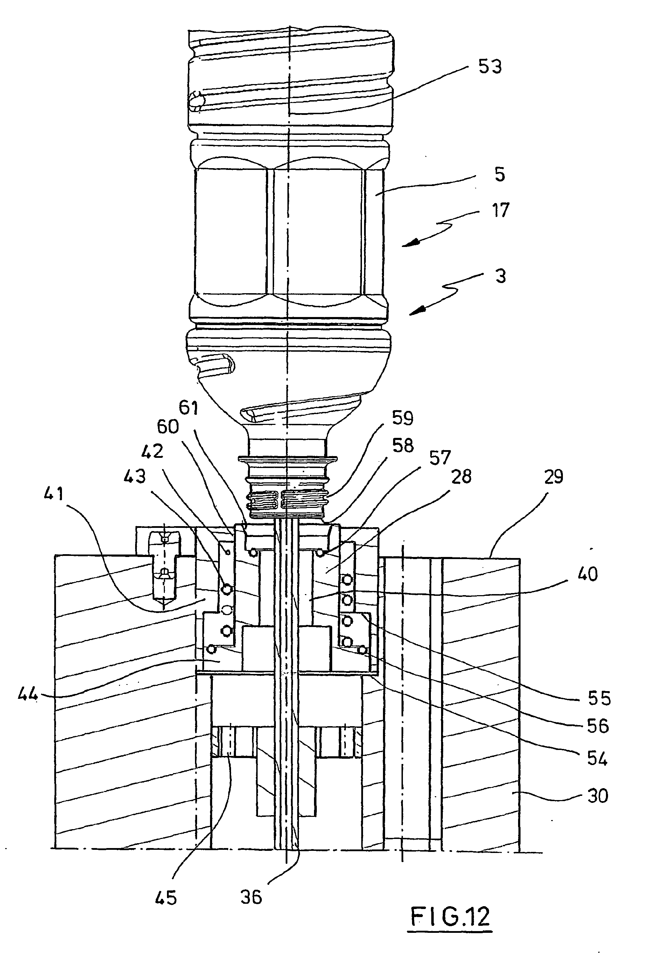

Fig. 12 zeigt die Anordnung gemäß Fig. 10 nach einem Anheben der Kammerwandung (18) und nach einem Absenken des Dichtelementes (28). Genau wie in Fig. 10 ist auch in Fig. 11 das Halteelement (46) gemäß Fig. 11 nicht dargestellt.

Das Dichtelement (28) ist gemäß Fig. 12 derart abgesenkt, daß eine seitliche Beweglichkeit des Werkstückes (5) erfolgen kann. Hierdurch ist ein seitliches Einsetzen vor der Plasmabehandlung sowie ein seitliches Entnehmen nach einem Abschluß der Plasmabehandlung möglich. Im dargestellten Betriebszustand ist der Außenflansch (44) des Dichtelementes (28) gegen einen Innensteg des Kammersockels (30) geführt. Der Innenflansch (54) definiert gemeinsam mit einem Innenflansch (55) der Führungshülse (41) den Bewegungsbereich des Dichtelementes (28). Ohne eine externe Stellkraft wird das Dichtelement (28) mit seinem Außenflansch (44) von der Druckfeder (43) gegen den Innenflansch (54) gedrückt.

Zur Gewährleitung einer ausreichenden Abdichtung kann der Außenflansch (44) im Bereich seiner dem Innenflansch (55) zugewandten Ausdehnung mit einer Ringdichtung (56) versehen werden. In einem angehobenen Zustand des Dichtelementes (28) wird hierdurch eine Abdichtung zwischen dem Außenflansch (44) und dem Innenflansch (55) vorgenommen. Alternativ kann auch eine dynamische Dichtung verwendet werden, bei der die Abdichtung radial im Bereich eines Außenumfanges erfolgt und bei einer Bewegung ein Entlanggleiten an der Dichtung durchgeführt wird. Das Dichtelement (28) weist darüber hinaus eine Ringdichtung (57) im Bereich seiner dem Werkstück (5) zugewandten Ausdehnung auf. Bei einem flaschenartigen Werkstück (5) wird diese Ringdichtung (57) gegen eine Mündungsfläche (58) eines Gewindebereiches (59) geführt. Zur äußeren Einfassung des Gewindebereiches (59) in einem angehobenen Zustand des Dichtelementes (28) weist das Dichtelement (28) darüber hinaus einen ringartigen Einfassungsflansch (60) auf, der innenseitig mit einer Einführanschrägung (61) versehen ist.

Das Dichteelement (28) kann insbesondere derart gestaltet sein, daß bei der in Fig. 12 dargestellten Positionierung nach einem Absenken der Kammerwandung (18) zunächst eine gemeinsame Evakuierung eines Innenraumes des Werkstückes (5) und des Innenraumes der Plasmakammer (17) erfolgt. Nach einem Anheben des Dichtelementes (28) wird zum einen der Innenraum der Plasmakammer (17) durch das Dichtelement (28) gegenüber der Vakuumzuführung abgedichtet, der Innenraum des.Werkstückes (5) bleibt jedoch weiterhin an die Vakuumzuführung angeschlossen. Es kann hierdurch ohne ein zusätzliches Steuerventil eine unterschiedliche Evakuierung des Innenraumes des Werkstückes (5) und des Innenraumes der Plasmakammer (17) durchgeführt werden.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Dichtelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird das Dichtelement (28) mindestens bereichsweise wieder in den Kammersockel (3) hinein verfahren.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

## Patentansprüche

1. Verfahren zur Plasmabehandlung von Werkstücken (5), bei dem das Werkstück (5) in eine zumindest teilweise evakuierbare Kammer (17) einer Behandlungsstation eingesetzt wird und bei dem das Werkstück (5) innerhalb der Behandlungsstation von einem Halteelement (46) positioniert wird, **dadurch gekennzeichnet, daß** das Werkstück (5) flaschenartig ausgebildet ist und zur Abdichtung eines Innenraums des Werkstücks (5) ein hülsenartiges Dichtelement (28) relativ zu einem Kammerboden (29) derart positioniert wird, dass die Positionierung in einer vertikalen Richtung durchgeführt wird und daß das Dichtelement (28) eine Ringdichtung (57) aufweist, die im abgedichteten Zustand gegen eine Mündungsfläche (58) eines Gewindebereichs (59) des flaschenartig ausgebildeten Werkstücks (5) geführt wird, und dass vor einem Einsetzen des Werkstückes (5) in die Kammer (17) das Dichtungselement (28) abgesenkt, dann das Werkstück (5) an das Haltelement (46) übergeben und anschließend das Dichtelement (28) wieder angehoben wird.

2. Verfahren nach Anspruch 1, **dadurch gekennzeichnet, daß** ein Dichtelement (28) mit einer kreisringartigen Querschnittfläche positioniert wird.

3. Verfahren nach einem der Ansprüche 1 oder 2, **dadurch gekennzeichnet, daß** eine Evakuierung einer Kavität (4) der Plasmastation (3) durch den Kammerboden (29) hindurch erfolgt.

4. Verfahren nach einem der Ansprüche 1 bis 3, **dadurch gekennzeichnet, daß** durch den Kammerboden (29) hindurch Prozeßgas zugeführt wird.

5. Verfahren nach einem der Ansprüche 1 bis 4, **dadurch gekennzeichnet, daß** das Prozeßgas durch eine Lanze (36) hindurch in einen Innenraum des Werkstückes (5) zugeführt wird.

6. Verfahren nach einem der Ansprüche 1 bis 5, **dadurch gekennzeichnet, daß** das Werkstück (5) seitlich von einem Einfassungsflansch (60) des Dichtelementes (28) abgestützt wird.

7. Verfahren nach Anspruch 6, **dadurch gekennzeichnet, daß** ein Mündungsbereich des Werkstückes (5) vom Einfassungsflansch (60) abgestützt wird.

8. Verfahren nach einem der Ansprüche 1 bis 7, **dadurch gekennzeichnet, daß** das Dichtelement (28) von einer Druckfeder (43) in eine der Plasmakammer (17) abgewandte Richtung gedrückt wird.

9. Verfahren nach einem der Ansprüche 1 bis 8, **dadurch gekennzeichnet, daß** ein Hubbereich des Dichtelementes (28) von mindestens zwei Anschlägen begrenzt wird.

10. Verfahren nach einem der Ansprüche 1 bis 9, **dadurch gekennzeichnet, daß** das Dichtelement (28) mechanisch positioniert wird.

11. Verfahren nach einem der Ansprüche 1 bis 9, **dadurch gekennzeichnet, daß** das Dichtelement (28) pneumatisch positioniert wird.

12. Verfahren nach einem der Ansprüche 1 bis 11, **dadurch gekennzeichnet, daß** im Bereich des Kammerdeckels (31) von einem Mikrowellengenerator (19) erzeugte Mikrowellen in die Kavität (4) eingeleitet werden.

13. Verfahren nach einem der Ansprüche 1 bis 12, **dadurch gekennzeichnet, daß** ein Werkstück (5) aus einem thermoplastischen Kunststoff behandelt wird.

14. Verfahren nach einem der Ansprüche 1 bis 13, **dadurch gekennzeichnet, daß** ein Innenraum eines hohlkörperartigen Werkstückes (5) behandelt wird.

15. Verfahren nach einem der Ansprüche 1 bis 14, **dadurch gekennzeichnet, daß** als Werkstück (5) ein Behälter behandelt wird.

16. Verfahren nach einem der Ansprüche 1 bis 15, **dadurch gekennzeichnet, daß** als Werkstück (5) eine Getränkeflasche behandelt wird.

17. Verfahren nach einem der Ansprüche 1 bis 16, **dadurch gekennzeichnet, daß** die mindestens eine Plasmastation (3) von einem rotierenden Plasmarad (2) von einer Eingabepositionierung in eine Ausgabepositionierung überführt wird.

18. Verfahren nach einem der Ansprüche 1 bis 17, **dadurch gekennzeichnet, daß** von einer Plasmastation (3) mehrere Kavitäten (4) bereitgestellt werden.

19. Verfahren nach einem der Ansprüche 1 bis 18, **dadurch gekennzeichnet, daß** das Dichtelement (28) eine Ventilfunktion zur steuerbaren Verbindung und Abtrennung des Innenraumes des Werkstückes (5) und des weiteren Innenraumes der Plasmakammer (17) ausübt.

20. Verfahren nach einem der Ansprüche 1 bis 19, **dadurch gekennzeichnet, daß** als Plasmabehandlung eine Plasmabeschichtung durchgeführt wird.

21. Verfahren nach einem der Ansprüche 1 bis 20, **dadurch gekennzeichnet, daß** die Plasmabehandlung unter Verwendung eines Niederdruckplasmas durchgeführt wird.

22. Verfahren nach einem der Ansprüche 1 bis 21, **dadurch gekennzeichnet, daß** eine Plasmapolymerisation durchgeführt wird.

23. Verfahren nach einem der Ansprüche 1 bis 22, **dadurch gekennzeichnet, daß** durch das Plasma mindestens zum Teil organische Substanzen abgeschieden werden.

24. Verfahren nach einem der Ansprüche 1 bis 22, **dadurch gekennzeichnet, daß** durch das Plasma mindestens zum Teil anorganische Substanzen abgeschieden werden.

25. Verfahren nach einem der Ansprüche 1 bis 24, **dadurch gekennzeichnet, daß** durch das Plasma eine Substanz zur Verbesserung von Barriereeigenschaften des Werkstückes (5) abgeschieden wird.

26. Verfahren nach Anspruch 25, **dadurch gekennzeichnet, daß** zusätzlich ein Haftvermittler zur Verbesserung eines Anhaftens der Substanz auf einer Oberfläche des Werkstückes (5) abgeschieden wird.

27. Verfahren nach einem der Ansprüche 1 bis 26, **dadurch gekennzeichnet, daß** in einer gemeinsamen Kavität mindestens zwei Werkstücke (5) gleichzeitig behandelt werden.

28. Verfahren nach einem der Ansprüche 1 bis 19, **dadurch gekennzeichnet, daß** als Plasmabehandlung eine Plasmasterilisation durchgeführt wird.

29. Verfahren nach einem der Ansprüche 1 bis 19, **dadurch gekennzeichnet, daß** als Plasmabehandlung eine Oberflächenaktivierung des Werkstückes (5) durchgeführt wird.

30. Vorrichtung zur Plasmabehandlung von Werkstücken (5), die mindestens eine evakuierbare Plasmakammer (17) zur Aufnahme der Werkstücke (5) aufweist und bei der die Plasmakammer (17) im Bereich einer Behandlungsstation angeordnet ist, sowie bei der die Plasmakammer (17) von einem Kammerboden (29), einem Kammerdeckel (31) sowie einer seitlichen Kammerwandung (18) begrenzt ist und mindestens ein Halteelement (46) zur Positionierung des Werkstückes (5) aufweist, **dadurch gekennzeichnet, dass** im Bereich des Kammerbodens (29) ein hülsenartiges Dichtelement (28) angeordnet ist, das relativ zum Kammerboden (29) derart beweglich angeordnet ist, dass das Dichtelement (28) in einer vertikalen Richtung positionierbar ist und dass das Dichtelement (28) eine Ringdichtung (57) aufweist, die im abgedichteten Zustand gegen eine Mündungsfläche (58) eines Gewindebereiches (59) des flaschenartig ausgebildeten Werkstückes (5) geführt wird, sowie dass das Dichtelement (28) relativ zum Kammerboden (29) sowohl absenkbar als auch anhebbar angeordnet ist.

31. Vorrichtung nach Anspruch 30, **dadurch gekennzeichnet, dass** das Dichtelement (28) eine kreisringförmige Querschnittfläche aufweist.

32. Vorrichtung nach einem der Ansprüche 30 oder 31, **dadurch gekennzeichnet, dass** für eine Evakuierung einer Kavität (4) der Plasmastation (3) im Kammerboden (29) mindestens ein Vakuumkanal angeordnet ist.

33. Vorrichtung nach einem der Ansprüche 30 bis 32, **dadurch gekennzeichnet, dass** im Kammerboden (29) mindestens ein Kanal zur Zuführung von Prozessgas angeordnet ist.

34. Vorrichtung nach einem der Ansprüche 30 bis 33, **dadurch gekennzeichnet, dass** zur Zuführung von Prozessgas in einen Innenraum des Werkstückes (5) hinein eine Lanze (36) relativ zum Kammerboden (29) positionierbar angeordnet ist.

35. Vorrichtung nach einem der Ansprüche 30 bis 34, **dadurch gekennzeichnet, dass** das Dichtelement (28) mit einem der Plasmakammer (17) zugewandt angeordneten Einfassungsflansch (60) versehen ist.

36. Vorrichtung nach Anspruch 35, **dadurch gekennzeichnet, daß** der Einfassungsflansch (60) zur seitlichen Umschließung mindestens eines Teiles eines Mündungsbereiches des Werkstückes (5) ausgebildet ist.

37. Vorrichtung nach Anspruch 35 oder 36, **dadurch gekennzeichnet, daß** der Einfassungsflansch (60) mit einer innenseitigen Einführanschrägung (61) versehen ist.

38. Vorrichtung nach einem der Ansprüche 30 bis 37, **dadurch gekennzeichnet, daß** das Dichtelement (28) eine der Plasmakammer zugewandt angeordnete Ringdichtung (57) aufweist.

39. Vorrichtung nach einem der Ansprüche 30 bis 38, **dadurch gekennzeichnet, daß** das Dichtelement (28) von einer Druckfeder (43) relativ zu einer äußeren Führungshülse (41) verspannt ist.

40. Vorrichtung nach einem der Ansprüche 30 bis 39, **dadurch gekennzeichnet, daß** ein Positionierweg des Dichtelementes (28) von mindestens zwei Anschlägen begrenzt ist.

41. Vorrichtung nach einem der Ansprüche 30 bis 40, **dadurch gekennzeichnet, daß** im Bereich des Kammerdeckels (31) ein Mikrowellengenerator (19) angeordnet ist.

42. Vorrichtung nach einem der Ansprüche 30 bis 41, **dadurch gekennzeichnet, daß** die Plasmastation (3) zur Beschichtung eines Werkstückes (5) aus einem thermoplastischen Kunststoff ausgebildet ist.

43. Vorrichtung nach einem der Ansprüche 30 bis 42, **dadurch gekennzeichnet, daß** die Plasmastation (3) zur Beschichtung eines behälterartigen Werkstückes (5) ausgebildet ist.

44. Vorrichtung nach einem der Ansprüche 30 bis 43, **dadurch gekennzeichnet, daß** die Plasmastation (3) zur Beschichtung eines Innenraumes eines hohlkörperartigen Werkstückes (5) ausgebildet ist.

45. Vorrichtung nach einem der Ansprüche 30 bis 44, **dadurch gekennzeichnet, daß** die Plasmastation (3) zur Beschichtung eines Werkstückes (5) in Form einer Getränkeflasche ausgebildet ist.

46. Vorrichtung nach einem der Ansprüche 30 bis 45, **dadurch gekennzeichnet, daß** die mindestens eine Plasmastation (3) von einem rotierenden Plasmarad (2) getragen ist.

47. Vorrichtung nach einem der Ansprüche 30 bis 46, **dadurch gekennzeichnet, daß** im Bereich der Plasmastation (3) mehrere Kavitäten (4) angeordnet sind.

48. Vorrichtung nach einem der Ansprüche 30 bis 47, **dadurch gekennzeichnet, daß** eine zur Bereitstellung von mindestens zwei Kavitäten (4) vorgesehene Kammerwandung (18) positionierbar angeordnet ist.

49. Vorrichtung nach einem der Ansprüche 30 bis 48, **dadurch gekennzeichnet, daß** das Dichtelement (28) mit einer mechanischen Positioniereinrichtung gekoppelt ist.

50. Vorrichtung nach Anspruch 49, **dadurch gekennzeichnet, daß** das Dichtelement (28) mit einem Lanzenschlitten (37) gekoppelt ist.

51. Vorrichtung nach Anspruch 49, **dadurch gekennzeichnet, daß** das Dichtelement (28) mit einer Lanze (36) zur Prozeßgaszuführung gekoppelt ist.

52. Vorrichtung nach Anspruch 51, **dadurch gekennzeichnet, daß** die Lanze (36) zur Positionierung des Dichtelementes (28) mit einem Schubteller (45) versehen ist.

53. Vorrichtung nach einem der Ansprüche 30 bis 52, **dadurch gekennzeichnet, daß** das Dichtelement (28) mit einer pneumatischen Positioniereinrichtung gekoppelt ist.

54. Vorrichtung nach Anspruch 53, **dadurch gekennzeichnet, daß** die pneumatische Positioniereinrichtung eine Überdrucksteuerung aufweist.

55. Vorrichtung nach Anspruch 53, **dadurch gekennzeichnet, daß** die pneumatische Positioniereinrichtung eine Unterdrucksteuerung aufweist.

56. Vorrichtung nach einem der Ansprüche 30 bis 55, **dadurch gekennzeichnet, daß** das Dichtelement (28) zur steuerbaren Verbindung und Trennung eines Innenraumes des Werkstückes (5) und des weiteren Innenraumes der Plasmakammer (17) ausgebildet ist.

57. Vorrichtung nach einem der Ansprüche 30 bis 56, **dadurch gekennzeichnet, daß** das Dichtelement (28) zur steuerbaren Verbindung und Abtrennung eines Innenraumes der Plasmakammer (17) mit einer Unterdruckquelle ausgebildet ist.

## Claims

1. A method for the plasma treatment of workpieces (5) in which the workpiece (5) is inserted into a chamber (17) of a treatment station, wherein said chamber (17) can be evacuated at least in part, and in which the workpiece (5) is positioned within the treatment station by a retaining element (46), **characterised in that** the workpiece (5) is formed like a bottle and, to seal an interior region of the workpiece (5), a sleeve-type sealing element (28) is positioned relative to a chamber bottom (29) in such a way that the positioning is made in a vertical direction and that the sealing element (28) comprises a ring seal (57) which, when being in the sealed state, is driven against an outlet surface (58) of a threaded region (59) of the workpiece (5) that is formed like a bottle, and that, prior to inserting the workpiece (5) into the chamber (17), the sealing element (28) is moved down, then the workpiece (5) is transferred to the retaining element (46) and, subsequently, the sealing element (28) is moved up again.

2. The method according to Claim 1, **characterised in that** a sealing element (28) having a cross-sectional area formed like a circular ring is positioned.

3. The method according to any one of Claims 1 or 2, **characterised in that** an evacuation of a cavity (4) of the plasma station (3) is achieved through the chamber bottom (29).

4. The method according to any one of Claims 1 to 3, **characterised in that** process gas is supplied through the chamber bottom (29).

5. The method according to any one of Claims 1 to 4, **characterised in that** the process gas is supplied through a lance (36) and into an interior region of the workpiece (5).

6. The method according to any one of Claims 1 to 5, **characterised in that** the workpiece (5) is supported laterally by a perimeter flange (60) of the sealing element (28).

7. The method according to Claim 6, **characterised in that** an outlet area of the workpiece (5) is supported by the perimeter flange (60).

8. The method according to any one of Claims 1 to 7, **characterised in that** the sealing element (28) is pressed in a direction facing away from the plasma chamber (17) by a pressure spring (43).

9. The method according to any one of Claims 1 to 8, **characterised in that** a stroke region of the sealing element (28) is delimited by at least two stops.

10. The method according to any one of Claims 1 to 9, **characterised in that** the sealing element (28) is positioned mechanically.

11. The method according to any one of Claims 1 to 9, **characterised in that** the sealing element (28) is positioned pneumatically.

12. The method according to any one of Claims 1 to 11, **characterised in that**, in the vicinity of the chamber lid (31), microwaves generated by a microwave generator (19) are introduced into the cavity (4).

13. The method according to any one of Claims 1 to 12, **characterised in that** a workpiece (5) that is made of a thermoplastic resin is treated.

14. The method according to any one of Claims 1 to 13, **characterised in that** an interior region of a hollow-type workpiece (5) is treated.

15. The method according to any one of Claims 1 to 14, **characterised in that** a container is treated as workpiece (5).

16. The method according to any one of Claims 1 to 15, **characterised in that** a beverage bottle is treated as workpiece (5).

17. The method according to any one of Claims 1 to 16, **characterised in that** a rotating plasma wheel (2) puts the at least one plasma station (3) from an input position to an output position.

18. The method according to any one of Claims 1 to 17, **characterised in that** a plurality of cavities (4) is made available by a plasma station (3).

19. The method according to any one of Claims 1 to 18, **characterised in that** the sealing element (28) carries out a valve function for connecting and disconnecting the interior region of the workpiece (5) and the further interior region of the plasma chamber (17) in a controllable manner.

20. The method according to any one of Claims 1 to 19, **characterised in that** a plasma coating is carried out as plasma treatment.

21. The method according to any one of Claims 1 to 20, **characterised in that** the plasma treatment is carried out using a low pressure plasma.

22. The method according to any one of Claims 1 to 21, **characterised in that** a plasma polymerisation is carried out.

23. The method according to any one of Claims 1 to 22, **characterised in that** organic substances are separated by the plasma at least in part.

24. The method according to any of Claims 1 to 22, **characterised in that** inorganic substances are separated by the plasma at least in part.

25. The method according to any of Claims 1 to 24, **characterised in that** a substance for improving barrier properties of a workpiece (5) is separated by the plasma.

26. The method according to Claim 25, **characterised in that**, in addition, an adhesion promoter is separated to improve an adhesion of the substance to a surface of the workpiece (5).

27. The method according to any one of Claims 1 to 26, **characterised in that** at least two workpieces (5) are treated at the same time in one common cavity.

28. The method according to any of Claims 1 to 19, **characterised in that** a plasma sterilisation is carried out as plasma treatment.

29. The method according to any one of Claims 1 to 19, **characterised in that** a surface activation of the workpiece (5) is carried out as plasma treatment.

30. An apparatus for the plasma treatment of workpieces (5), which comprises at least one plasma chamber (17) that can be evacuated and is provided to receive the workpieces (5) and in which the plasma chamber (17) is arranged in the vicinity of a treatment station as well as in which the plasma chamber (17) is delimited by a chamber bottom (29), a chamber lid (31) as well as a lateral chamber wall (18) and comprises at least one retaining element (46) for positioning the workpiece (5), **characterised in that** a sleeve-type sealing element (28) is arranged in the vicinity of the chamber bottom (29), said sleeve-type sealing element (28) being arranged relative to the chamber bottom (29) in a movable manner in such a way that the sealing element (28) can be positioned in a vertical direction and that the sealing element (28) comprises a ring seal (57) which, when being in the sealed state, is driven against an outlet surface (58) of a threaded region (59) of the workpiece (5) that is formed like a bottle, as well as that the sealing element (28) is arranged relative to the chamber bottom (29) such that it can be moved down and moved up.

31. The apparatus according to Claim 30, **characterised in that** the sealing element (28) comprises a cross-sectional area that is formed like a circular ring.

32. The apparatus according to any one of Claims 30 or 31, **characterised in that**, to evacuate a cavity (4) of the plasma station (3), at least one vacuum duct is arranged in the chamber bottom (29).

33. The apparatus according to any one of Claims 30 to 32, **characterised in that** at least one duct for supplying process gas is arranged in the chamber bottom (29).

34. The apparatus according to any one of Claims 30 to 33, **characterised in that**, to supply process gas into an interior region of the workpiece (5), a lance (36) is arranged such that it can be positioned relative to the chamber bottom (29).

35. The apparatus according to any one of Claims 30 to 34, **characterised in that** the sealing element (28) is provided with a perimeter flange (60) that is arranged such that it faces the plasma chamber (17).

36. The apparatus according to Claim 35, **characterised in that** the perimeter flange (60) is formed to laterally enclose at least a part of an outlet area of the workpiece (5).

37. The apparatus according to Claim 35 or 36, **characterised in that** the perimeter flange (60) is provided with an inside insertion chamfer (61).

38. The apparatus according to any one of Claims 30 to 37, **characterised in that** the sealing element (28) comprises a ring seal (57) that is arranged such that it faces the plasma chamber.

39. The apparatus according to any one of Claims 30 to 38, **characterised in that** the sealing element (28) is tensioned relative to an outer guide sleeve (41) by a pressure spring (43).

40. The apparatus according to any one of Claims 30 to 39, **characterised in that** a positioning path of the sealing element (28) is delimited by at least two stops.

41. The apparatus according to any one of Claims 30 to 40, **characterised in that** a microwave generator (19) is arranged in the vicinity of the chamber lid (31).

42. The apparatus according to any one of Claims 30 to 41, **characterised in that** the plasma station (3) is formed to coat a workpiece (5) that is made of a thermoplastic resin.

43. The apparatus according to any one of Claims 30 to 42, **characterised in that** the plasma station (3) is formed to coat the container-type workpiece (5).

44. The apparatus according to any one of Claims 30 to 43, **characterised in that** the plasma station (3) is formed to coat an interior region of a hollow-type workpiece (5).

45. The apparatus according to any one of Claims 30 to 44, **characterised in that** the plasma station (3) is formed to coat a workpiece (5) having the form of a beverage bottle.

46. The apparatus according to any one of Claims 30 to 45, **characterised in that** the at least one plasma station (3) is held by a rotating plasma wheel (2).

47. The apparatus according to any one of Claims 30 to 46, **characterised in that** a plurality of cavities (4) is arranged in the vicinity of the plasma station (3).

48. The apparatus according to any one of Claims 30 to 47, **characterised in that** a chamber wall (18) is arranged such that it can be positioned to make available at least two cavities (4).

49. The apparatus according to any one of Claims 30 to 48, **characterised in that** the sealing element (28) is coupled to a mechanical positioning device.

50. The apparatus according to Claim 49, **characterised in that** the sealing element (28) is coupled to a lance carriage (37).

51. The apparatus according to Claim 49, **characterised in that** the sealing element (28) is coupled to a lance (36) for supplying process gas.

52. The apparatus according to Claim 51, **characterised in that** the lance (36) is provided with a push disc (45) for positioning the sealing element (28).

53. The apparatus according to any one of Claims 30 to 52, **characterised in that** the sealing element (28) is coupled to a pneumatic positioning device.

54. The apparatus according to Claim 53, **characterised in that** the pneumatic positioning device comprises an excess pressure control.

55. The apparatus according to Claim 53, **characterised in that** the pneumatic positioning device comprises a vacuum pressure control.

56. The apparatus according to any one of Claims 30 to 55, **characterised in that** the sealing element (28) is formed for connecting and disconnecting an interior region of the workpiece (5) and the further interior region of the plasma chamber (17) in a controllable manner.

57. The apparatus according to any one of Claims 30 to 56, **characterised in that** the sealing element (28) is formed with a vacuum pressure source for connecting and disconnecting an interior region of the plasma chamber (17) in a controllable manner.

## Revendications

1. Procédé de traitement au plasma de pièces d'oeuvre (5) dans le cadre duquel la pièce d'oeuvre (5) est introduite dans une chambre (17) d'une station de traitement, laquelle chambre peut, en partie au moins, être évacuée, et est positionnée par un élément de maintien (46) à l'intérieur de la station de traitement, **caractérisé en ce que** la pièce d'oeuvre (5) a une forme de bouteille et que, en vue de l'étanchéification d'un espace intérieur de la pièce d'oeuvre (5), un élément d'étanchéification (28) en forme de douille est positionné par rapport à un fond (29) de la chambre de façon telle que le positionnement est effectué selon une direction verticale, l'élément d'étanchéification (28) présentant un joint annulaire (57) qui, en position d'étanchéification, est placé contre une surface d'embouchure (58) d'une section filetée (59) de la pièce d'oeuvre en forme de bouteille (5), et **en ce que**, avant l'introduction de la pièce d'oeuvre (5) dans la chambre (17), l'élément d'étanchéification (28) est abaissé, puis la pièce d'oeuvre (5) est remise à l'élément de maintien (46), après quoi l'élément d'étanchéification (28) est à nouveau relevé.

2. Procédé selon la revendication 1, **caractérisé en ce qu'**un élément d'étanchéification (28) de section transversale en anneau de cercle est positionné.

3. Procédé selon l'une des revendications 1 ou 2, **caractérisé en ce qu'**une évacuation d'une cavité (4) de la station de plasma (3) a lieu à travers le fond (29) de la chambre.

4. Procédé selon l'une des revendications 1 à 3, **caractérisé en ce qu'**un gaz de procédé est introduit par le fond (29) de la chambre.

5. Procédé selon l'une des revendications 1 à 4, **caractérisé en ce que** le gaz de procédé est introduit par une lance (36) dans un espace intérieur de la pièce d'oeuvre (5).

6. Procédé selon l'une des revendications 1 à 5, **caractérisé en ce que** la pièce d'oeuvre (5) est maintenue latéralement par une collerette (60) de l'élément d'étanchéification (28).

7. Procédé selon la revendication 6, **caractérisé en ce qu'**une section d'embouchure de la pièce d'oeuvre (5) est soutenue par la collerette (60).

8. Procédé selon l'une des revendications 1 à 7, **caractérisé en ce que** l'élément d'étanchéification (28) est pressé par un ressort de pression (43) dans une direction opposée à la chambre à plasma (17).

9. Procédé selon l'une des revendications 1 à 8, **caractérisé en ce qu'**une hauteur de levée de l'élément d'étanchéification (28) est délimité par au moins deux butées.

10. Procédé selon l'une des revendications 1 à 9, **caractérisé en ce que** l'élément d'étanchéification (28) est positionné mécaniquement.

11. Procédé selon l'une des revendications 1 à 9, **caractérisé en ce que** l'élément d'étanchéification (28) est positionné pneumatiquement.

12. Procédé selon l'une des revendications 1 à 11, **caractérisé en ce que** des micro-ondes produites par un générateur de micro-ondes (19) sont introduites dans la cavité (4) au niveau du couvercle (31) de la chambre.

13. Procédé selon l'une des revendications 1 à 12, **caractérisé en ce qu'**une pièce d'oeuvre (5) traitée est une pièce en matière plastique thermoplastique.

14. Procédé selon l'une des revendications 1 à 13, **caractérisé en ce qu'**un espace intérieur d'une pièce d'oeuvre (5) creuse est traitée.

15. Procédé selon l'une des revendications 1 à 14, **caractérisé en ce que** la pièce d'oeuvre (5) traitée est un récipient.

16. Procédé selon l'une des revendications 1 à 15, **caractérisé en ce que** la pièce d'oeuvre (5) traitée est une bouteille pour boissons.

17. Procédé selon l'une des revendications 1 à 16, **caractérisé en ce que** la ou les station(s) de plasma (3) est ou sont déplacée(s) d'un positionnement d'introduction en un positionnement de sortie par une roue de traitement au plasma (2) en rotation.

18. Procédé selon l'une des revendications 1 à 17, **caractérisé en ce qu'**une station de plasma (3) met à disposition plusieurs cavités (4).

19. Procédé selon l'une des revendications 1 à 18, **caractérisé en ce que** l'élément d'étanchéification (28) exerce une fonction de soupape pour assurer sur commande la communication ou l'isolation de l'espace intérieur de la pièce d'oeuvre (5) et du restant de l'espace intérieur de la chambre à plasma (17).

20. Procédé selon l'une des revendications 1 à 19, **caractérisé en ce que** le traitement au plasma est réalisé sous forme de revêtement par plasma.

21. Procédé selon l'une des revendications 1 à 20, **caractérisé en ce que** le traitement au plasma fait appel à un plasma basse pression.

22. Procédé selon l'une des revendications 1 à 21, **caractérisé en ce que** l'on effectue une polymérisation par plasma.

23. Procédé selon l'une des revendications 1 à 22, **caractérisé en ce que** le plasma dépose en partie au moins des substances organiques.

24. Procédé selon l'une des revendications 1 à 22, **caractérisé en ce que** le plasma dépose en partie au moins des substances anorganiques.

25. Procédé selon l'une des revendications 1 à 24, **caractérisé en ce que** le plasma dépose une substance améliorant les propriétés de barrière de la pièce d'oeuvre (5).

26. Procédé selon la revendication 25, **caractérisé en ce qu'**est en outre déposé un agent de pontage pour améliorer l'adhésion de la substance à la surface de la pièce d'oeuvre (5).

27. Procédé selon l'une des revendications 1 à 26, **caractérisé en ce que** deux pièces d'oeuvre (5) au moins sont traitées simultanément dans une cavité commune.

28. Procédé selon l'une des revendications 1 à 19, **caractérisé en ce que** le traitement au plasma appliqué est une stérilisation par plasma.

29. Procédé selon l'une des revendications 1 à 19, **caractérisé en ce que** le traitement au plasma appliqué est une activation de surface de la pièce d'oeuvre (5).

30. Dispositif de traitement au plasma de pièces d'oeuvre (5) présentant, pour recevoir ces pièces (5), au moins une chambre à plasma (17) pouvant être évacuée agencée dans la zone d'une station de traitement, cette chambre à plasma (17) étant délimitée par un fond de chambre (29), un couvercle de chambre (31) ainsi qu'une paroi latérale (18) et munie d'au moins un élément de maintien (46) assurant le positionnement de la pièce d'oeuvre (5), **caractérisé en ce que**, au niveau du fond (29) de la chambre, est placé un élément d'étanchéification (28) en forme de douille mobile agencé par rapport au fond (29) de la chambre de façon à ce que l'élément d'étanchéification (28) puisse être positionné en sens vertical, et **en ce que** l'élément d'étanchéification (28) présente un joint annulaire (57) lequel, en position d'étanchéification, est placé contre une surface d'embouchure (58) d'une section filetée (59) de la pièce d'oeuvre en forme de bouteille (5), et **en ce que** l'élément d'étanchéification (28) peut aussi bien être abaissé que relevé par rapport au fond (29) de la chambre.

31. Dispositif selon la revendication 30, **caractérisé en ce que** l'élément d'étanchéification (28) présente une section transversale en forme d'anneau de cercle.

32. Dispositif selon l'une des revendications 30 ou 31, **caractérisé en ce que** un canal à vide au moins est aménagé dans le fond (29) de la chambre pour l'évacuation d'une cavité (4) de la station de plasma (3).

33. Dispositif selon l'une des revendications 30 à 32, **caractérisé en ce que** un canal au moins est aménagé dans le fond (29) de la chambre pour l'adduction d'un gaz de procédé.

34. Dispositif selon l'une des revendications 30 à 33, **caractérisé en ce que** une lance (36) pour l'adduction d'un gaz de procédé dans un espace intérieur de la pièce d'oeuvre (5) est agencée de façon à pouvoir être positionnée par rapport au fond (29) de la chambre.

35. Dispositif selon l'une des revendications 30 à 34, **caractérisé en ce que** l'élément d'étanchéification (28) est muni d'une collerette (60) orientée vers la chambre à plasma (17).

36. Dispositif selon la revendication 35, **caractérisé en ce que** la collerette (60) est conformée de façon à pouvoir entourer latéralement une partie au moins d'une section d'embouchure de la pièce d'oeuvre (5).

37. Dispositif selon la revendication 35 ou 36, **caractérisé en ce que** la collerette (60) est munie d'un chanfrein d'introduction intérieur (61).

38. Dispositif selon l'une des revendications 30 à 37, **caractérisé en ce que** l'élément d'étanchéification (28) présente un joint annulaire (57) orienté vers la chambre à plasma.

39. Dispositif selon l'une des revendications 30 à 38, **caractérisé en ce qu'**un ressort de pression (43) assure le serrage élastique de l'élément d'étanchéification (28) par rapport par rapport à une douille de guidage (41) extérieure.

40. Dispositif selon l'une des revendications 30 à 39, **caractérisé en ce qu'**une course de positionnement de l'élément d'étanchéification (28) est délimité par au moins deux butées.

41. Dispositif selon l'une des revendications 30 à 40, **caractérisé en ce qu'**un générateur de micro-ondes (19) est placé au niveau du couvercle (31) de la chambre.

42. Dispositif selon l'une des revendications 30 à 41, **caractérisé en ce que** la station de plasma (3) est conçue pour appliquer un revêtement d'une matière plastique thermoplastique à l'intérieur d'une pièce d'oeuvre (5).

43. Dispositif selon l'une des revendications 30 à 42, **caractérisé en ce que** la station de plasma (3) est conçue pour appliquer un revêtement à l'intérieur d'une pièce d'oeuvre (5) en forme de récipient.

44. Dispositif selon l'une des revendications 30 à 43, **caractérisé en ce que** la station de plasma (3) est conçue pour appliquer un revêtement à l'intérieur d'une pièce d'oeuvre (5) creuse.

45. Dispositif selon l'une des revendications 30 à 44, **caractérisé en ce que** la station de plasma (3) est conçue pour appliquer un revêtement à l'intérieur d'une pièce d'oeuvre (5) en forme de bouteille pour boissons.

46. Dispositif selon l'une des revendications 30 à 45, **caractérisé en ce que** la ou les station(s) de plasma (3) est ou sont portée(s) par une roue de traitement au plasma (2) en rotation.

47. Dispositif selon l'une des revendications 30 à 46, **caractérisé en ce que** plusieurs cavités (4) sont agencées dans la zone de la station de plasma (3).

48. Dispositif selon l'une des revendications 30 à 47, **caractérisé en ce que** une paroi (18) prévue pour mettre à disposition au moins deux cavités (4) est placée de façon à pouvoir être positionnée.

49. Dispositif selon l'une des revendications 30 à 48, **caractérisé en ce que** l'élément d'étanchéification (28) est couplé à un dispositif de positionnement mécanique.

50. Dispositif selon la revendication 49, **caractérisé en ce que** l'élément d'étanchéification (28) est couplé à un chariot pour lance (37).

51. Dispositif selon la revendication 49, **caractérisé en ce que** l'élément d'étanchéification (28) est couplé à une lance (36) d'adduction d'un gaz de procédé.

52. Dispositif selon la revendication 51, **caractérisé en ce que** la lance (36) est dotée d'un plateau pousseur (45) pour le positionnement de l'élément d'étanchéification (28).

53. Dispositif selon l'une des revendications 30 à 52, **caractérisé en ce que** l'élément d'étanchéification (28) est couplé à un dispositif de positionnement pneumatique.

54. Dispositif selon la revendication 53, **caractérisé en ce que** le dispositif de positionnement pneumatique est doté d'une commande à surpression.

55. Dispositif selon la revendication 53, **caractérisé en ce que** le dispositif de positionnement pneumatique est doté d'une commande à dépression.

56. Dispositif selon l'une des revendications 30 à 55, **caractérisé en ce que** l'élément d'étanchéification (28) est conçu pour assurer sur commande la communication ou l'isolation d'un espace intérieur de la pièce d'oeuvre (5) et du restant de l'espace intérieur de la chambre à plasma (17).

57. Dispositif selon l'une des revendications 30 à 56, **caractérisé en ce que** l'élément d'étanchéification (28) est conçu pour assurer sur commande la communication ou l'isolation d'un espace intérieur de la chambre à plasma (17) et d'une source de dépression.
